(19) **Europäisches Patentamt**

**European Patent Office**

**Office européen des brevets**

(11) **EP 1 167 982 B1**

(12) **FASCICULE DE BREVET EUROPEEN**

(45) Date de publication et mention
de la délivrance du brevet:
**12.04.2006 Bulletin 2006/15**

(51) Int Cl.:
**G01R 15/24** *(2006.01)*

(21) Numéro de dépôt: **01410060.6**

(22) Date de dépôt: **22.05.2001**

(54) **Dispositif de mesure d'un courant électrique par effet faraday**

Anordnung zum Messen des elektrischen Stromes durch den Faraday-Effekt

Electric current measuring appliance using the Faraday effect

(84) Etats contractants désignés:
**CH DE ES GB IT LI SE**

(30) Priorité: **30.06.2000 FR 0008480**

(43) Date de publication de la demande:
**02.01.2002 Bulletin 2002/01**

(73) Titulaire: **SCHNEIDER ELECTRIC INDUSTRIES SAS**
**92500 Rueil-Malmaison (FR)**

(72) Inventeur: **Minier, Vincent,**
**Schneider Electric Industries**
**38050 Grenoble cedex 09 (FR)**

(74) Mandataire: **Tripodi, Paul et al**
**Schneider Electric Industries SA**
**Propriété Industrielle-A7**
**38050 Grenoble Cedex 09 (FR)**

(56) Documents cités:
**US-A- 4 564 754         US-A- 4 973 899**

## Description

L'invention concerne un dispositif de mesure d'un courant électrique par effet Faraday, comportant :

- une source lumineuse fournissant un faisceau lumineux incident,
- un polariseur d'entrée pour polariser linéairement le faisceau lumineux incident,
- un transducteur magnéto-optique recevant le faisceau lumineux incident polarisé,
- un séparateur de faisceau, disposé à la sortie du transducteur et fournissant des premier et second faisceaux lumineux de sortie,
- un polariseur de sortie, disposé sur le trajet du premier faisceau lumineux de sortie,
- une unité de traitement comportant une première entrée optique, connectée à la sortie du polariseur de sortie, une seconde entrée optique, recevant le second faisceau lumineux de sortie directement du séparateur de faisceau, et des moyens de conversion opto-électronique connectés aux premières et seconde entrées optiques pour fournir des premier et second signaux électriques à des moyens de calcul numérique du courant à mesurer,

Dans un capteur de courant à effet Faraday, le plan de polarisation d'une lumière incidente polarisée subit une rotation, qui est fonction du champ magnétique créé par le courant électrique à mesurer. La détermination de l'angle de rotation du plan de polarisation de la lumière en sortie de capteur optique permet de déterminer le courant à mesurer.

En l'absence de mesures spécifiques, la mesure est sensible aux dérives de puissance optique du capteur, aux variations de température, aux vibrations du capteur ainsi qu'aux bruits optique et électronique dans l'ensemble de la chaîne de mesure.

Dans la plupart des capteurs de courant à effet Faraday connus, un analyseur de polarisation décompose le faisceau optique de sortie du transducteur magnéto-optique en deux composantes optiques polarisées linéairement selon des axes orthogonaux. Ces composantes optiques sont converties en signaux électriques dont l'analyse permet la détermination du courant à mesurer.

Le document FR-A-2686422 décrit un capteur de ce type dans lequel les signaux électriques représentatifs des deux composantes optiques sont traités par deux voies de mesure distinctes avant d'être appliqués aux moyens de calcul. Dans l'une des voies de mesure les signaux électriques sont appliqués à un amplificateur à gain variable. Le capteur calcule ensuite le rapport $\Delta/\Sigma$ entre la différence $\Delta = I_1 - GI_2$ et la somme $\Sigma = I_1 + GI_2$, dans laquelle $I_1$ et $I_2$ sont respectivement représentatifs des intensités des deux composants optiques et $G$ est le gain de l'amplificateur à gain variable. Ce capteur permet ainsi de s'affranchir des dérives optiques, ainsi que du bruit optique en amont de l'analyseur de polarisation.

Le document WO-A-9510046 décrit un capteur dans lequel les signaux électriques S1 et S2 représentatifs des deux composants optiques sont normalisés pour former un signal $P = (S1 - S2) / (S1 + S2)$. Les composantes alternative PAC et continue PDC de ce signal sont utilisées pour calculer un signal compensé en température, de préférence sous la forme : $PAC / (1 + KPDC)$, où $K$ est un coefficient de correction.

Par ailleurs, l'article « A common-mode optical noise-rejection scheme for an extrinsic Faraday current sensor », de Fisher et al. (1996, IOP Publishing Ltd), décrit un capteur optique de courant éliminant le bruit optique commun induit par les vibrations de fibres optiques de liaison. Le faisceau optique de sortie du transducteur magnéto-optique est divisé en deux faisceaux par un séparateur accolé au transducteur. Les deux faisceaux, dont l'un passe à travers un polariseur, sont guidés par des fibres optiques vers deux photodiodes. Le courant à mesurer est calculé à partir de la différence entre les signaux électriques fournis par les photodiodes. Ce type de capteur ne permet de compenser ni le bruit optique différentiel, ni les dérives, ni le bruit dû au circuit de traitement électronique. Il ne compense pas non plus les variations de température.

Le capteur optique décrit dans le brevet US 5.008.611 est rendu insensible aux variations de biréfringence, dues notamment aux variations de température, grâce à un choix approprié de l'angle que fait la direction de polarisation du polariseur d'entrée avec un axe propre du transducteur magnéto-optique. Dans ce document, le faisceau optique de sortie du transducteur, polarisé linéairement, n'est pas séparé en deux composantes. Le courant à mesurer est calculé à partir du rapport entre les composantes alternative et continue d'un signal électrique représentatif de l'intensité du faisceau optique de sortie polarisé. Ce type de capteur reste sensible au bruit optique dans la bande passante de mesure.

L'invention a pour but un dispositif de mesure d'un courant électrique par effet Faraday ne présentant pas les inconvénients des dispositifs connus.

Ce but est atteint par le fait que les moyens de calcul comportent des moyens de calcul d'une première grandeur constituée par le rapport entre les premier et second signaux électriques, des moyens de détermination des composantes alternative et continue de la première grandeur, des moyens de calcul d'une seconde grandeur à partir des composantes alternative et continue de la première grandeur et des moyens de calcul du courant à mesurer à partir de la seconde grandeur.

Selon un premier développement de l'invention la seconde grandeur est obtenue en faisant le rapport entre les composantes alternative et continue de la première grandeur.

Selon un second développement de l'invention la seconde grandeur S est obtenue selon l'équation :

$$S \approx \frac{R_{AC}}{1 + a(R_{DC} - 1)}$$

dans laquelle $R_{AC}$ et $R_{DC}$ sont respectivement les composantes alternative et continue de la première grandeur et a est un coefficient d'ajustement.

Le séparateur de faisceau est, est de préférence, disposé le plus près possible de l'unité de traitement et connecté au transducteur par une fibre optique à maintien de polarisation. Il est ainsi possible de minimiser l'influence des bruits optiques différentiels.

Selon un autre développement de l'invention les moyens de conversion opto-électronique comportent deux photodiodes, formées sur un même substrat semi-conducteur et associées respectivement aux première et seconde entrées optiques de l'unité de traitement, deux amplificateurs, formés sur un même substrat semi-conducteur, étant connectés en sortie des photodiodes. Les bruits et dérives électroniques différentiels sont ainsi minimisés.

Selon un autre développement de l'invention les moyens de conversion opto-électronique comportent des première et secondes photodiodes connectées aux première et seconde entrées optiques de l'unité de traitement, l'unité de traitement comportant des premier et second amplificateurs respectivement connectés aux sorties des première et seconde photodiodes, des moyens de détermination de la composante continue des signaux de sortie de l'un desdits amplificateurs, des moyens de détermination d'une première différence, entre les signaux de sortie du premier amplificateur et des moyens de détermination de la composante continue des signaux de sortie de l'un desdits amplificateurs, des moyens de détermination d'une seconde différence, entre les signaux de sortie du second amplificateur et des moyens de détermination de la composante continue des signaux de sortie de l'un desdits amplificateurs, les sorties des moyens de détermination de la composante continue des signaux de sortie de l'un desdits amplificateurs et des moyens de détermination des première et seconde différences étant connectées à des entrées d'un circuit électronique de traitement numérique qui comporte des moyens de reconstitution, à partir des signaux appliqués sur ses entrées, des premier et second signaux électriques utilisés par les moyens de calcul de la première grandeur, l'unité de traitement comportant des amplificateurs de gain g prédéterminé, connectés entre les moyens de détermination des première et seconde différences et les entrées associées du circuit électronique de traitement numérique, les premier et second signaux électriques Ui, utilisés par les moyens de calcul de la première grandeur étant déterminés selon l'équation :

$$Ui = (Ai / g) + A3$$

avec i = 1, 2 et dans laquelle A1, A2 et A3 sont respectivement les signaux appliqués aux entrées du circuit électronique de traitement numérique.

Selon un autre développement de l'invention, les moyens de conversion opto-électronique comportent des première et seconde photodiodes connectées aux première et seconde entrées optiques de l'unité de traitement, l'unité de traitement comportant des premier et second amplificateurs respectivement connectés aux sorties des première et seconde photodiodes, des moyens de détermination des composantes continues des signaux de sortie desdits amplificateurs, des moyens de détermination des composantes alternatives des signaux de sortie desdits amplificateurs, les sorties des moyens de détermination des composantes continues et alternatives des signaux de sortie desdits amplificateurs étant connectées à des entrées d'un circuit électronique de traitement numérique qui comporte des moyens de reconstitution, à partir des signaux appliqués sur ses entrées, de signaux électriques utilisés par les moyens de calcul de la première grandeur, l'unité de traitement comportant des amplificateurs de gain g prédéterminé, connectés entre les moyens de détermination des composantes alternatives et les entrées associées du circuit électronique de traitement numérique, les signaux électriques V1 et V2 utilisés par les moyens de calcul de la première grandeur étant déterminés selon les équations :

$$V1 = B_1 + B_2$$

$$V2 = B_3 + B_4$$

dans lesquelles $B_1$, $B_2$, $B_3$ et $B_4$ sont respectivement les signaux appliqués aux entrées du circuit électronique de traitement numérique.

D'autres avantages et caractéristiques ressortiront plus clairement de l'exposé qui va suivre de modes de réalisation particuliers de l'invention, donnés à titre d'exemples non limitatifs et représentés aux dessins annexés sur lesquels :

La figure 1 représente un mode particulier de réalisation d'un dispositif selon l'invention.
La figure 2 représente, plus en détail, un mode de réalisation particulier de l'unité de traitement du dispositif selon la figure 1.
Les figures 3 et 5 représentent des variantes de l'unité de traitement du dispositif selon la figure 1.
Les figures 4 et 6 représentent des modes particuliers de réalisation d'un organigramme de fonctionnement pouvant être utilisés respectivement par les variantes des figures 3 et 5.
Les figures 7 à 9 illustrent divers modes de réalisation du séparateur de faisceau du dispositif selon la figure 1.

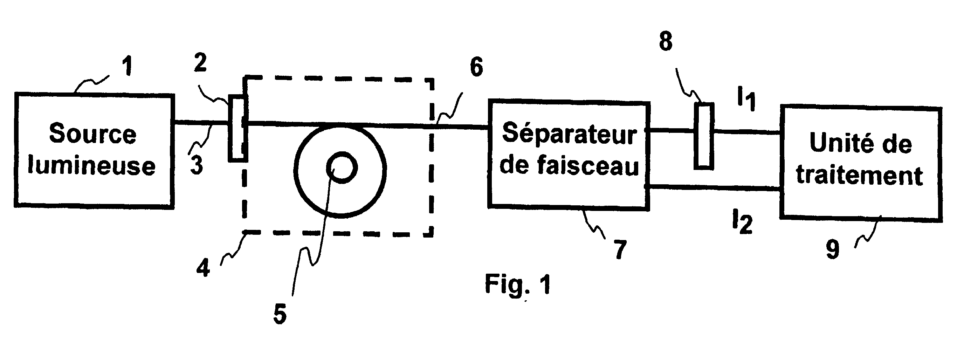

Le dispositif de mesure de courant électrique par effet Faraday représenté à la figure 1 comporte, classiquement, une source lumineuse 1 fournissant un faisceau lumineux incident. Le faisceau lumineux incident est polarisé linéairement par un polariseur d'entrée 2 auquel il est amené par une fibre optique 3, monomode et à maintien de polarisation. Le faisceau lumineux incident polarisé est appliqué à l'entrée d'un transducteur magnéto-optique 4. Dans le mode de réalisation de la figure 1, le transducteur 4 est constitué par une fibre optique entourant un conducteur 5 dans lequel circule le courant 1 à mesurer. Le faisceau lumineux obtenu à la sortie du transducteur 4 est amené par une fibre optique 6, monomode et à maintien de polarisation, à un séparateur de faisceau 7 qui fournit à deux voies de mesure, respectivement, des premier et second faisceaux lumineux de sortie. Dans la première voie de mesure, un polariseur de sortie 8 est disposé sur le trajet du premier faisceau lumineux de sortie, de manière à polariser celui-ci linéairement. Le premier faisceau lumineux de sortie polarisé, d'intensité I1, est appliqué à une première entrée optique d'une unité de traitement 9. Dans la seconde voie de mesure, le second faisceau lumineux de sortie, d'intensité 12, est appliqué directement, à partir du séparateur, à une seconde entrée optique de l'unité de traitement 9.

De manière classique, l'unité de traitement 9 comporte des moyens de conversion opto-électronique comportant deux photodiodes 10 associées respectivement aux première et seconde entrées optiques de l'unité de traitement. Chacune des photodiodes 10 est connectée aux bornes d'un amplificateur 11 associé. On obtient ainsi, respectivement, en sortie de chacune des deux voies de mesure, des premier et second signaux électriques U1 et U2, respectivement représentatifs de l'intensité I1 et 12 des premier et second faisceaux lumineux de sortie.

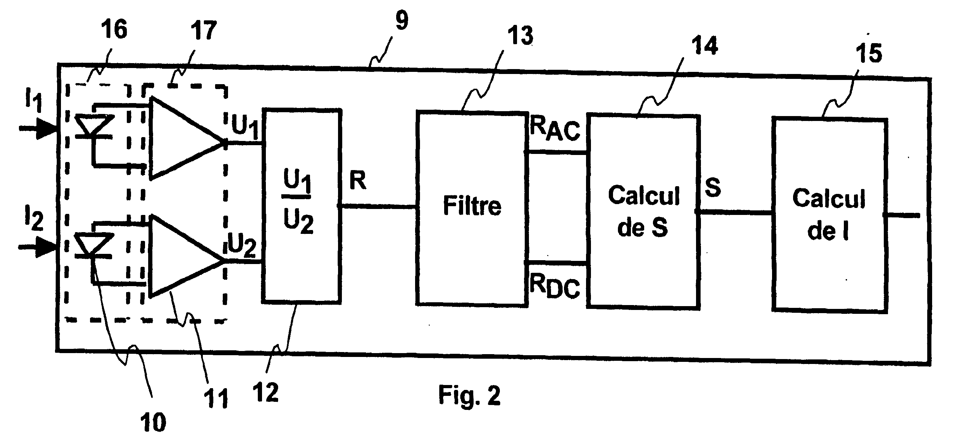

L'unité de traitement comporte des moyens de calcul numérique du courant I à mesurer auxquels sont appliqués les premier et second signaux électriques U1 et U2. Dans le mode de réalisation particulier représenté à la figure 2, les moyens de calcul comportent un circuit 12 de calcul d'une première grandeur R constituée par le rapport U1 / U2 entre les premier et second signaux électriques. Il comporte ensuite un circuit 13, par exemple constitué par un filtre, de détermination des composantes alternative $R_{AC}$ et continue $R_{DC}$ de la première grandeur. Les composantes $R_{AC}$ et $R_{DC}$ sont appliquées à l'entrée d'un circuit 14 de calcul d'une seconde grandeur S, elle-même appliquée à l'entrée d'un circuit 15 de calcul du courant I à mesurer.

Sur la figure 2 les circuits 12 à 15 sont représentés sous forme de circuits séparés. Les différents calculs étant réalisés sous forme numérique, ils peuvent également être effectués par un microprocesseur.

Selon un premier mode de réalisation de l'invention, la seconde grandeur S est obtenue en faisant le rapport entre les composantes alternative $R_{AC}$ et continue $R_{DC}$ de la première grandeur R :

$$S = R_{AC} / R_{DC} \qquad\qquad (1)$$

Le courant I à mesurer, proportionnel à la seconde grandeur S, peut en être déduit. On obtient ainsi une valeur du courant I à mesurer qui est simultanément insensible aux dérives de puissance optique, aux dérives des photodiodes 10, des amplificateurs 11, ainsi qu'aux bruits optiques communs (en amont du séparateur de faisceau 7), notamment à ceux compris dans la bande passante du capteur. Ce traitement du signal est, de plus, compatible avec la mise en oeuvre d'une compensation des effets de la température sur le transducteur 4.

En effet, les intensités I1 et 12 des premier et second faisceau lumineux de sortie appliqués aux entrées optiques de l'unité de traitement peuvent s'écrire sous la forme :

$$I1 = \alpha_1 \, I_0 \, ( \, 1 + \beta_{Opt} \, ) \, ( \, A + B2VNI) \qquad (2)$$

$$I2 = \alpha_2 \, I_0 \, ( \, 1 + \beta_{Opt} \, ) \qquad (3)$$

équations dans lesquelles :

- $\alpha_1$ et $\alpha_2$ représentent respectivement les coefficients des pertes d'insertion de la totalité de la chaîne optique dans les deux voies de mesure, jusqu'aux première et seconde entrées optiques de l'unité de traitement. Ces coefficients, qui dépendent notamment de la température de la source lumineuse 1 et du transducteur 4, sont représentatifs des dérives de puissance optique.
- $I_0$ est l'intensité du faisceau lumineux incident fourni par la source lumineuse 1.
- $\beta_{Opt}$ est représentatif du bruit optique en intensité, du notamment aux fluctuations optiques des signaux dans la bande passante du dispositif.
- A et B sont des constantes pouvant varier lentement en fonction des fluctuations de température de la source lumineuse et du transducteur.
- V est la constante de Verdet du transducteur magnéto-optique 4.
- N est le nombre, connu, de tours effectué par le faisceau lumineux autour du conducteur 5 dans le transducteur 4.
- 1 est l'intensité du courant électrique alternatif à mesurer.

Seul le signal I1 contient des informations relatives au courant à mesurer, tandis que les deux signaux I1 et 12 comportent des informations relatives au bruit et aux dérives optiques.

Les signaux U 1 et U2 représentatifs de I1 et 12 peuvent être représentés sous la forme :

$$U1 = \eta_1 \, G_1 \, I1 \qquad (4)$$

$$U2 = \eta_2 \, G_2 \, I2 \qquad (5)$$

Où:

- $\eta_1$ et $\eta_2$ représentent respectivement les rendements de conversion des photodiodes 10 des deux voies de mesure.
- $G_1$ et $G_2$ représentent respectivement les gains des amplificateurs 11 des deux voies de mesure.

La première grandeur R = U1 / U2, peut donc s'écrire :

$$R = \frac{\eta_1 G_1 \alpha_1}{\eta_2 G_2 \alpha_2} (A + B2VNI) \qquad (6)$$

La composante alternative de la première grandeur est obtenue par filtrage dans la bande passante du capteur, adaptée à la fréquence des courants alternatifs I à mesurer et comprise de préférence entre 0,1Hz et quelques kHz, et peut s'écrire :

$$R_{AC} = \frac{\eta_1 G_1 \alpha_1}{\eta_2 G_2 \alpha_2} B2VNI \qquad (7)$$

La composante continue de la première grandeur peut s'écrire :

$$R_{DC} = \frac{\eta_1 G_1 \alpha_1}{\eta_2 G_2 \alpha_2} A \tag{8}$$

A partir des équations (1), (7) et (8), la seconde grandeur S est alors donnée par :

$$S = \frac{B}{A} 2VNI \tag{9}$$

Le calcul de I s'affranchit ainsi simultanément des coefficients $\alpha_1, \alpha_2, \beta_{Opt}, \eta_1, \eta_2, G_1$ et $G_2$.

Dans un mode de réalisation préférentiel, les positions angulaires des polariseurs d'entrée et de sortie (2, 8) sont ajustées par rapport aux axes propres de biréfringence du transducteur 4, de manière analogue au dispositif du brevet US5.008.611. Un choix approprié de ces angles permet de s'affranchir des fluctuations lentes de la biréfringence du transducteur avec la température.

Dans une variante de réalisation la seconde grandeur S est donnée par l'équation suivante :

$$S = \frac{R_{AC}}{1 + a(R_{DC} - 1)} \tag{10}$$

dans laquelle a est un coefficient d'ajustement, réglable électroniquement. L'introduction du coefficient a permet, de manière analogue au dispositif selon le document WO-A-9510046, d'ajuster plus finement la compensation en température et ainsi d'améliorer l'insensibilité du dispositif aux variations de température.

Dans les équations ci-dessus le bruit différentiel, aussi bien optique qu'électronique, entre les deux voies de mesure a été négligé. En pratique, les équations (2) et (3) devraient être complétées selon les équations suivantes :

$$I1 = \alpha_1 I_0 (1 + \beta_{Opt})(1 + \beta_{1oe})(A + 2VNI) \tag{11}$$

$$I2 = \alpha_2 I_0 (1 + \beta_{Opt})(1 + \beta_{2oe}) \tag{12}$$

dans lesquelles les coefficients $\beta_{1oe}$ et $\beta_{2oe}$ sont respectivement représentatifs du bruit différentiel, optique et électronique, sur les deux voies de mesure.

Les coefficients $\beta_{1oe}$ et $\beta_{2oe}$ sont nuls en dehors de la bande passante du capteur. La composante continue de la première grandeur est donc inchangée. Par contre, en tenant compte du bruit différentiel, l'équation (6) doit être remplacée par l'équation suivante :

$$R = \frac{\eta_1 G_1 \alpha_1}{\eta_2 G_2 \alpha_2} \frac{1 + \beta_{1oe}}{1 + \beta_{2oe}} (A + B2VNI) \tag{13}$$

Pour réduire au maximum l'influence du bruit optique différentiel, le séparateur de faisceau 7 est disposé le plus près possible de l'unité de traitement 9, réduisant ainsi la longueur des deux voies de mesure optiques séparées. Le séparateur de faisceau est alors, de préférence, connecté au transducteur 4 par une fibre optique 6 monomode à maintien de polarisation qui peut être très longue. A titre d'exemple, la fibre 6 peut avoir une longueur de plusieurs mètres dans une application à un capteur de courant dans un dispositif haute tension.

L'influence du bruit électronique différentiel peut être réduite par un choix approprié des photodiodes 10 et des amplificateurs 11 des deux voies de mesure de l'unité de traitement 9, par exemple par l'utilisation de photodiodes 10 doubles, c'est-à-dire formées sur un même substrat semi-conducteur 16, et d'amplificateurs 11 doubles, formés sur un même substrat semi-conducteur 17. Les substrats 16 et 17 peuvent éventuellement être constitués par un substrat unique. Les coefficients $\beta_{1oe}$ et $\beta_{2oe}$ sont alors plus proches et la seconde grandeur S devient moins sensible aux bruits différentiels.

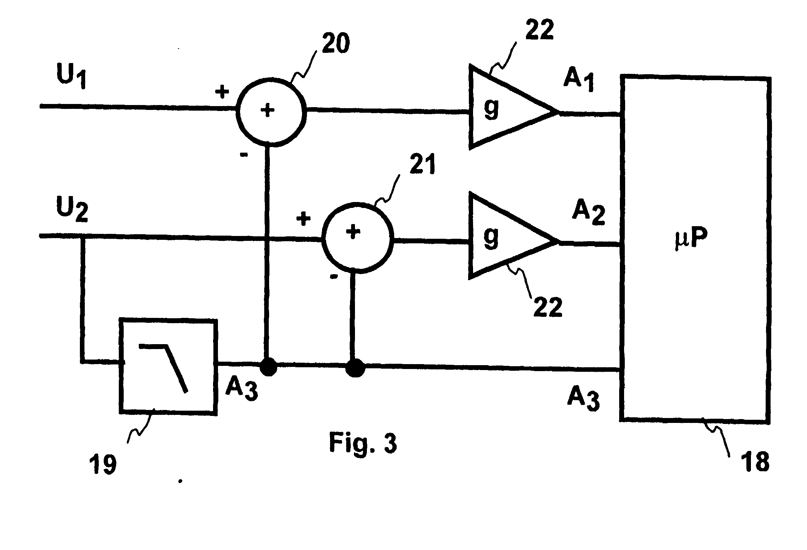

La variante de l'unité de traitement représentée à la figure 3 permet d'écarter les limitations liées à des problèmes de saturation des amplificateurs des voies de mesure. La partie analogique des voies de mesure est modifiée pour fournir des signaux $A_1$, $A_2$ et $A_3$ à trois entrées d'un circuit électronique de traitement numérique, qui est constitué par un microprocesseur 18 dans le mode de réalisation particulier représenté à la figure 3. Les signaux $A_3$ sont représentatifs de la composante continue des signaux électriques de sortie de l'un des amplificateurs 11 du circuit de traitement. Sur la figure 3, les signaux $A_3$ sont obtenus au moyen d'un filtre passe-bas 19 recevant les seconds signaux électriques U2.

Les signaux U1 sont appliqués à une première entrée, positive, d'un premier opérateur 20, qui reçoit les signaux $A_3$ sur une seconde entrée, négative, de manière à faire la différence entre les signaux U1 et $A_3$. De manière analogue, un second opérateur 21 reçoit les signaux U2 sur une première entrée, positive, et les signaux $A_3$ sur une seconde entrée négative, de manière à faire la différence entre les signaux U2 et $A_3$. Les signaux de sortie des premier et second opérateurs 20 et 21 sont respectivement appliqués à des amplificateurs 22, de gain g prédéterminé, fournissant des signaux de différence amplifiés $A_1 = g (U1 - A_3)$ et $A_2 = g (U2 - A_3)$ au microprocesseur 18. Les signaux $A_3$ sont représentatifs du niveau continu des signaux U1 et U2, qui est relativement important vis-à-vis de leurs variations. En effet, dans l'équation (2) le terme A est proche de l'unité tandis que le terme B2VNI est de l'ordre de $10^{-5}$. L'annulation des composantes continues des signaux U1 et U2 permet de réaliser un effet de zoom sur leurs composantes variables, qui peuvent alors être amplifiées par les amplificateurs 22 sans risquer la saturation.

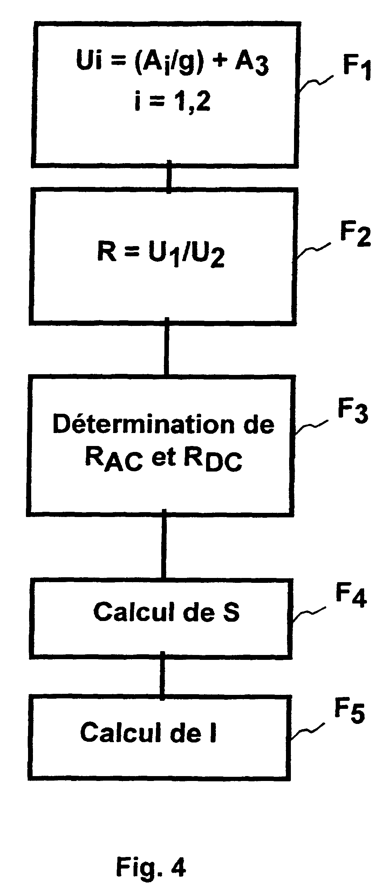

Le microprocesseur 18 reconstitue ensuite, à partir des signaux $A_1$, $A_2$ et $A_3$, les signaux U1 et U2, qu'il utilise ensuite, comme décrit précédemment, pour le calcul de R, S et I. Pour cela, comme illustré par l'organigramme de la figure 4, le microprocesseur 18 calcule dans une étape F1 les signaux Ui reconstitués, i = 1,2 selon l'équation :

$$Ui = (A_i \, / \, g) + A_3 \qquad (14)$$

On peut vérifier que les signaux Ui reconstitués sont bien égaux aux signaux U1 et U2 de sortie des amplificateurs 11. En effet, pour i = 1 par exemple :

$$(A_1/g) + A_3 \simeq \quad [g \, (U - A_3) \, /g] + A_3 \simeq U_1 \qquad (15)$$

Le microprocesseur 18 calcule ensuite (étape F2) la première grandeur R, puis détermine (étape F3) les composantes alternatives $R_{AC}$ et continue $R_{DC}$ de la première grandeur. Il calcule ensuite (étape F4) la seconde grandeur S conformément aux équations (1) ou (10), puis (étape F5) le courant I à mesurer conformément à l'équation (9).

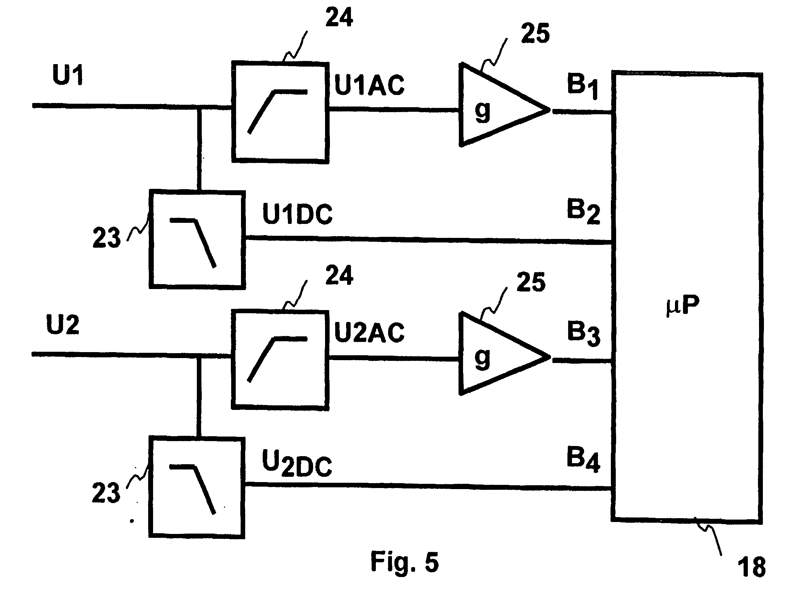

Dans la variante de la figure 5, la partie analogique des voies de mesure fournit des signaux $B_1$, $B_2$, $B_3$ et $B_4$ à quatre entrées du circuit électronique de traitement numérique constitué par le microprocesseur 18. Les signaux $B_1$ et $B_3$ sont représentatifs des composantes alternatives U1AC et U2AC des signaux U1 et U2 de sortie des amplificateurs 11, tandis que les signaux $B_2$ et $B_3$ sont représentatifs des composantes continues U1DC et U2DC des signaux U1 et U2, obtenues au moyen de filtres passe-bas 23. Les composantes alternatives U1AC et U2AC, obtenues au moyen de filtres passe-haut 24, sont respectivement appliquées à des amplificateurs 25, de gain g prédéterminé, fournissant les signaux $B_1$ et $B_3$ au microprocesseur 18.

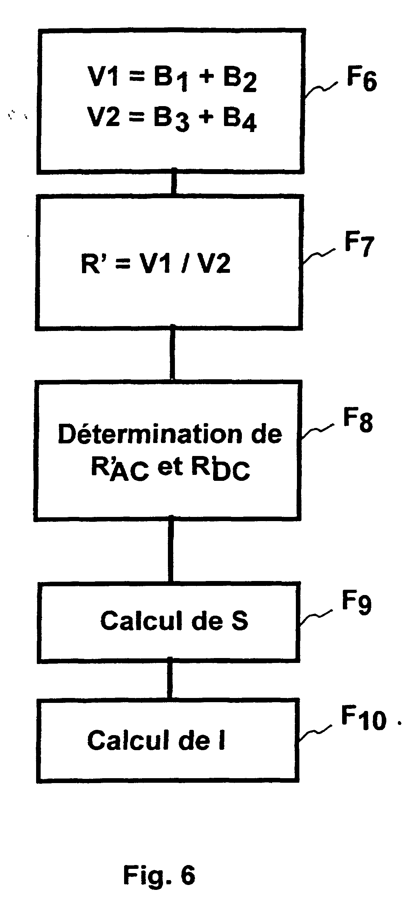

Comme représenté sur l'organigramme de la figure 6, le microprocesseur 18 reconstitue (étape F6) des signaux V1 et V2 à partir des signaux $B_1$ à $B_4$ et utilise ensuite les signaux reconstitués pour déterminer le courant I à mesurer. Dans l'étape F6, le microprocesseur calcule les signaux V1 et V2 selon les équations :

$$V1 = B_1 + B_2 \qquad (16)$$

$$V2 = B_3 + B_4 \qquad (17)$$

Le microprocesseur 18 calcule ensuite (étape F7) la première grandeur R' = V1 / V2, puis détermine (étape F8) les composantes alternatives R'$_{AC}$ et continue R'$_{DC}$ de la première grandeur.

On peut montrer que, dans ce mode de réalisation, avec une approximation du premier ordre, la première grandeur R' peut s'écrire :

$$R' \cong \frac{\eta_1 G_1 \alpha_1}{\eta_2 G_2 \alpha_2}(A + gB2VNI) \qquad (18)$$

Le rapport S' = R'$_{AC}$ / R'$_{DC}$ peut donc s'écrire :

$$S' = g\frac{B}{A}2VNI \qquad (19)$$

d'où l'on peut déduire la seconde grandeur S = S'/g. Le microprocesseur 18 calcule (étape F9) S' et la seconde grandeur S, puis (étape F10) le courant I à mesurer.

Les filtres et les amplificateurs sont choisis de manière à ce qu les filtres et les gains soient les mêmes sur les deux voies de mesure. A titre de variante de réalisation, il est possible de multiplexer les signaux, en utilisant un seul filtre passe-bas, un seul filtre passe-haut et un seul amplificateur.

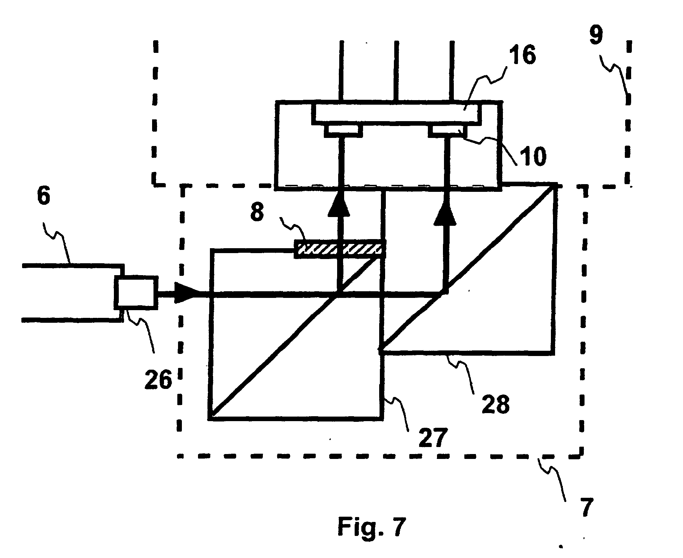

La figure 7 représente un mode de réalisation préférentiel du séparateur de faisceau 7, comportant des cubes non polarisants. Le faisceau lumineux de sortie du transducteur 4 est amené au séparateur de faisceau 7 par la fibre optique 6, dont l'extrémité peut être munie d'un collimateur 26. Le séparateur de faisceau 7 est constitué par deux cubes non polarisants à prismes semi-réfléchissants 27 et 28 disposés de manière à être légèrement décalés l'un par rapport à l'autre. Le faisceau lumineux de sortie du transducteur 4 est divisé en deux faisceaux par le premier cube 27, l'un traversant le cube tandis que l'autre est réfléchi par la diagonale du cube 27. La disposition et le décalage des cubes 27 et 28 sont tels que l'un des faisceaux, constituant le premier faisceau de sortie, sort directement du séparateur de faisceau et traverse le polariseur de sortie 8, qui est de préférence accolé au premier cube 27, tandis que l'autre faisceau est réfléchi par la diagonale du second cube 28 pour constituer le second faisceau de sortie, qui sort du séparateur de faisceau 7 parallèlement au premier faisceau de sortie. Sur la figure 7, le premier faisceau de sortie est constitué par le faisceau réfléchi par le cube 27. Dans une variante de réalisation, la fibre 6 peut être disposée dans le prolongement du premier faisceau de sortie, qui est alors constitué par le faisceau traversant le premier cube 27, tandis que le second faisceau de sortie est alors constitué par le faisceau réfléchi par les deux cubes 27 et 28. Dans le mode de réalisation préférentiel représenté que la figure 7, les photodiodes 10 de l'unité de traitement, montées sur un même substrat semi-conducteur 16, sont disposées dans un boîtier accolé contre le second cube 27, de manière à réduire au minimum la distance entre le séparateur de faisceau 7 et l'unité de traitement 9.

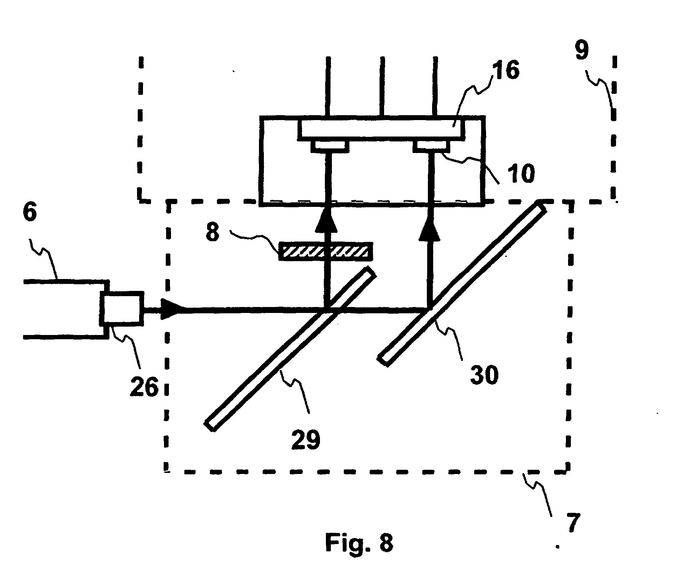

La figure 8 représente une variante du séparateur de faisceau 7, comportant des lames séparatrices 29 et 30.

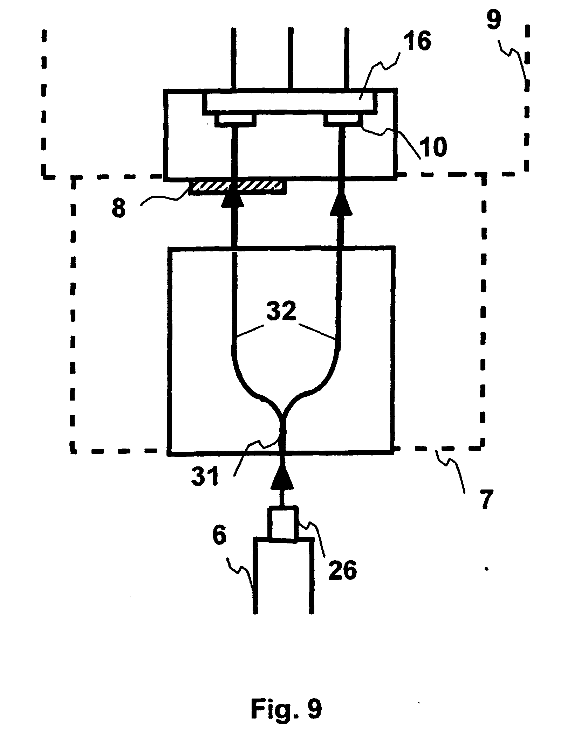

La figure 9 représente une autre variante du séparateur 7, constitué par un élément d'optique intégrée. Le faisceau lumineux de sortie du transducteur 4 est appliqué à l'entrée d'un guide d'onde d'entrée 31, puis après division en deux faisceaux par une jonction de type Y, passe dans deux guides d'onde de sortie 32, formés sur un même substrat. L'écartement des guides d'onde de sortie 32 est ajusté à la distance entre les zones sensibles des photodiodes 10. Comme sur les figures 7 et 8, un polariseur 8 est inséré en amont de l'une des photodiodes. Pour maintenir l'information codée en polarisation, les guides d'onde 31 et 32 sont de préférence des guides à biréfringence linéaire nulle. Alternativement, il est possible d'utiliser des guides biréfringents, à condition d'aligner les axes neutres de biréfringence de la fibre 6 à maintien de polarisation et du guide d'onde d'entrée 31.

Le séparateur 7 de faisceau pourrait également être obtenu simplement en laissant le faisceau de sortie diverger librement à la sortie du transducteur 4 ou de la fibre optique 7 et en plaçant le polariseur de sortie 8 sur une partie seulement du faisceau divergent.

Pour compenser les bruits en polarisation dans les fibres optiques 3 et 6, à forte biréfringence on peut orienter les fibres de façon à créer, de manière connue (EP-A-577897) des pseudo-dépolariseurs. Pour cela, les axes neutres de la fibre 3 (fig. 1) sont orientés à 45° par rapport au plan de polarisation du faisceau lumineux incident fourni par la source lumineuse 1. Celle-ci est, de préférence, constituée par une diode laser multimode ou une source superluminescente. Les axes neutres de la fibre 6 sont, de préférence orientés à 45° par rapport à l'axe de polarisation du polariseur 2.

L'invention n'est pas limitée aux modes de réalisation particuliers décrits ci-dessus. En particulier, le transducteur 4 peut être de tout type connu et être réalisé en optique intégrée.

## Revendications

1. Dispositif de mesure d'un courant électrique par effet Faraday, comportant

   • une source lumineuse (1) fournissant un faisceau lumineux incident,
   • un polariseur d'entrée (2) pour polariser linéairement le faisceau lumineux incident,
   • un transducteur magnéto-optique (4) recevant le faisceau lumineux incident polarisé,
   • un séparateur de faisceau (7), disposé à la sortie du transducteur (4) et fournissant des premier et second faisceaux lumineux de sortie,
   • un polariseur de sortie (8), disposé sur le trajet du premier faisceau lumineux de sortie,
   • une unité de traitement (9) comportant une première entrée optique, connectée à la sortie du polariseur de sortie, une seconde entrée optique, recevant le second faisceau lumineux de sortie directement du séparateur de faisceau, et des moyens de conversion opto-électronique (10) connectés aux première et seconde entrées optiques pour fournir des premier et second signaux électriques (U1, U2) à des moyens de calcul numérique du courant (I) à mesurer,
   dispositif **caractérisé en ce que** les moyens de calcul comportent des moyens (12) de calcul d'une première grandeur (R) constituée par le rapport (U1/U2) entre les premier et second signaux électriques (U1, U2), des moyens (13) de détermination des composantes alternative ($R_{AC}$) et continue ($R_{DC}$) de la première grandeur, des moyens (14) de calcul d'une seconde grandeur (S) à partir des composantes alternative et continue de la première grandeur et des moyens (15) de calcul du courant (I) à mesurer à partir de la seconde grandeur.

2. Dispositif selon la revendication 1, **caractérisé en ce que** la seconde grandeur (S) est obtenue en faisant le rapport ($R_{AC}/R_{DC}$) entre les composantes alternative ($R_{AC}$) et continue ($R_{DC}$) de la première grandeur.

3. Dispositif selon la revendication 1, **caractérisé en ce que** la seconde grandeur S est obtenue selon l'équation :

$$S = \frac{R_{AC}}{1 + a(R_{DC} - 1)}$$

dans laquelle $R_{AC}$ et $R_{DC}$ sont respectivement les composantes alternative et continue de la première grandeur et a est un coefficient d'ajustement.

4. Dispositif selon l'une quelconque des revendications 1 à 3, **caractérisé en ce que** le séparateur de faisceau (7) est disposé le plus près possible de l'unité de traitement (9).

5. Dispositif selon la revendication 4, **caractérisé en ce que** le séparateur de faisceau (7) est connecté au transducteur (4) par une fibre optique (6) monomode à maintien de polarisation.

6. Dispositif selon l'une quelconque des revendications 1 à 5, **caractérisé en ce que** les moyens de conversion opto-électronique comportent deux photodiodes (10), formées sur un même substrat semi-conducteur (16) et associées respectivement aux première et seconde entrées optiques de l'unité de traitement (9), deux amplificateurs (11), formés sur un même substrat semi-conducteur (17), étant connectés en sortie des photodiodes (10).

7. Dispositif selon l'une quelconque des revendications 1 à 6, **caractérisé en ce que** le séparateur de faisceau (7) comporte des cubes non polarisants (27, 28).

8. Dispositif selon l'une quelconque des revendications 1 à 6, **caractérisé en ce que** le séparateur de faisceau (7) comporte des lames séparatrices (29, 30).

9. Dispositif selon l'une quelconque des revendications 1 à 6, **caractérisé en ce que** le séparateur de faisceau (7) est constitué par des éléments d'optique intégrée (31, 32).

10. Dispositif selon l'une quelconque des revendications 1 à 9, **caractérisé en ce que** les moyens de conversion opto-électronique comportent des première et secondes photodiodes (10) connectées aux première et seconde entrées optiques de l'unité de traitement (9), l'unité de traitement (9) comportant des premier et second amplificateurs (11) respectivement connectés aux sorties des première et seconde photodiodes, des moyens (19) de détermination de la composante continue ($A_3$) des signaux de sortie de l'un desdits amplificateurs, des moyens (20) de détermination d'une première différence, entre les signaux (U1, $A_3$) de sortie du premier amplificateur et des moyens (19) de détermination de la composante continue des signaux de sortie de l'un desdits amplificateurs, des moyens (21) de détermination d'une seconde différence, entre les signaux (U2, $A_3$) de sortie du second amplificateur et des moyens (19) de détermination de la composante continue des signaux de sortie de l'un desdits amplificateurs, les sorties des moyens (19) de détermination de la composante continue des signaux de sortie de l'un desdits amplificateurs et des moyens (20, 21 ) de détermination des première et seconde différences étant connectées à des entrées d'un circuit électronique de traitement numérique (18) qui comporte des moyens (F1) de reconstitution, à partir des signaux ($A_1$, $A_2$, $A_3$) appliqués sur ses entrées, des premier et second signaux électriques utilisés par les moyens (F2) de calcul de la première grandeur (R), l'unité de traitement (9) comportant des amplificateurs (22) de gain g prédéterminé, connectés entre les moyens de détermination des première et seconde différences et les entrées associées du circuit électronique de traitement numérique (18), les premier et second signaux électriques Ui, avec i = 1 ou 2, utilisés par les moyens de calcul de la première grandeur étant déterminés selon l'équation :

$$Ui = (A_i / g) + A_3$$

avec i = 1, 2 et dans laquelle $A_1$, $A_2$ et $A_3$ sont respectivement les signaux appliqués aux entrées du circuit électronique de traitement numérique (18).

**11.** Dispositif selon l'une quelconque des revendications 1 à 9, **caractérisé en ce que** les moyens de conversion opto-électronique comportent des première et seconde photodiodes (10) connectées aux première et seconde entrées optiques de l'unité de traitement (9), l'unité de traitement (9) comportant des premier et second amplificateurs (11) respectivement connectés aux sorties des première et seconde photodiodes, des moyens (23) de détermination des composantes continues (U1DC, U2DC) des signaux de sortie (U1, U2) desdits amplificateurs, des moyens (24) de détermination des composantes alternatives (U1AC, U2AC) des signaux de sortie (U1, U2) desdits amplificateurs, les sorties des moyens (23, 24) de détermination des composantes continues et alternatives des signaux de sortie desdits amplificateurs étant connectées à des entrées d'un circuit électronique de traitement numérique (18) qui comporte des moyens (F6) de reconstitution, à partir des signaux ($B_1$, $B_2$, $B_3$, $B_4$) appliqués sur ses entrées, de signaux électriques (V1, V2) utilisés par les moyens (F7) de calcul de la première grandeur (R'), l'unité de traitement (9) comportant des amplificateurs (25) de gain g prédéterminé, connectés entre les moyens (24) de détermination des composantes alternatives et les entrées ($B_1$, $B_3$) associées du circuit électronique de traitement numérique (18), les signaux électriques V1 et V2 utilisés par les moyens de calcul de la première grandeur (R') étant déterminés selon les équations :

$$V1 = B_1 + B_2$$

$$V2 = B_3 + B_4$$

dans lesquelles $B_1$, $B_2$, $B_3$ et $B_4$ sont respectivement les signaux appliqués aux entrées du circuit électronique de traitement numérique (18).

**Claims**

**1.** Device for measuring an electric current by Faraday effect, comprising:

- a light source (1) supplying an incident light beam,
- an input polarizer (2) to polarize the incident light beam linearly,
- a magneto-optical transducer (4) receiving the polarized incident light beam,
- a beam separator (7) arranged at the output of the transducer (4) and supplying first and second output light beams,
- an output polarizer (8) arranged on the path of the first output light beam,
- a processing unit (9) comprising a first optical input connected to the output of the output polarizer, a second optical input receiving the second output light beam directly from the beam separator, and means for opto-electronic conversion (10) connected to the first and second optical inputs to supply first and second electric signals (U1, U2) to computing means for digital computation of the current (I) to be measured,

device **characterized in that** the computing means comprise means (12) for computing a first quantity (R) constituted by the ratio (U1/U2) between the first and second electric signals (U1, U2), means (13) for determining the AC component ($R_{AC}$) and DC component ($R_{DC}$) of the first quantity, means (14) for computing a second quantity (S) from the AC and DC components of the first quantity, and means (15) for computing the current (I) to be measured from the second quantity.

2. Device according to claim 1, **characterized in that** the second quantity (S) is obtained by calculating the ratio ($R_{AC}/R_{DC}$) between the AC component ($R_{AC}$) and the DC component ($R_{DC}$) of the first quantity.

3. Device according to claim 1, **characterized in that** the second quantity S is obtained according to the equation:

$$S = \frac{R_{AC}}{1 + a(R_{DC} - 1)}$$

in which $R_{AC}$ and $R_{DC}$ are respectively the AC and DC components of the first quantity and a is an adjustment coefficient.

4. Device according to any one of the claims 1 to 3, **characterized in that** the beam separator (7) is located as close as possible to the processing unit (9).

5. Device according to claim 4, **characterized in that** the beam separator (7) is connected to the transducer (4) by a monomode, polarization maintaining optical fiber (6).

6. Device according to any one of the claims 1 to 5, **characterized in that** the means for opto-electronic conversion comprise two photodiodes (10) formed on a single semiconducting substrate (16) and associated respectively to the first and second optical inputs of the processing unit (9), two amplifiers (11) formed on a single semiconducting substrate (17) being connected on output of the photodiodes (10).

7. Device according to any one of the claims 1 to 6, **characterized in that** the beam separator (7) comprises non-polarizing cubes (27, 28).

8. Device according to any one of the claims 1 to 6, **characterized in that** the beam separator (7) comprises separating blades (29, 30).

9. Device according to any one of the claims 1 to 6, **characterized in that** the beam separator (7) is formed by integrated optics elements (31, 32).

10. Device according to any one of the claims 1 to 9, **characterized in that** the means for opto-electronic conversion comprise first and second photodiodes (10) connected to the first and second optical inputs of the processing unit (9), the processing unit (9) comprising first and second amplifiers (11) respectively connected to the outputs of the first and second photodiodes, means (19) for determining the DC component ($A_3$) of the output signals of one of said amplifiers, means (20) for determining a first difference between the output signals (U1, $A_3$) of the first amplifier and means (19) for determining the DC component of the output signals of one of said amplifiers, means (21) for determining a second difference between the output signals (U2, $A_3$) of the second amplifier and means (19) for determining the DC component of the output signals of one of said amplifiers, the outputs of the means (19) for determining the DC component of the output signals of one of said amplifiers and of the means (20, 21) for determining the first and second differences being connected to inputs of a digital electronic processing circuit (18) comprising means (F1) for reconstituting, from the signals ($A_1$, $A_2$, $A_3$) applied to its inputs, the first and second electric signals used by the means (F2) for computing the first quantity (R), the processing unit (9) comprising amplifiers (22) of preset gain g, connected between the means for determining the first and second differences and the associated inputs of the digital electronic processing circuit (18), the first and second electric signals Ui, with i = 1 or 2, used by the means for computing the first quantity, being determined according to the equation:

$$Ui = (A_i \, / \, g) + A_3$$

with i = 1, 2 and in which $A_1$, $A_2$ and $A_3$ are respectively the signals applied to the inputs of the digital electronic processing circuit (18).

11. Device according to any one of the claims 1 to 9, **characterized in that** the means for opto-electronic conversion comprise first and second photodiodes (10) connected to the first and second optical inputs of the processing unit (9), the processing unit (9) comprising first and second amplifiers (11) respectively connected to the outputs of the first and second photodiodes, means (23) for determining the DC components (U1DC, U2DC) of the output signals (U1, U2) of said amplifiers, means (24) for determining the AC components (UIAC, U2AC) of the output signals (U1, U2) of said amplifiers, the outputs of the means (23, 24) for determining the DC and AC components of the output signals of said amplifiers being connected to inputs of a digital electronic processing circuit (18) comprising means (F6) for reconstituting, from the signals ($B_1$, $B_2$, $B_3$, $B_4$) applied to its inputs, electric signals (V1, V2) used by the means (F7) for computing the first quantity (R'), the processing unit (9) comprising amplifiers (25), of preset gain g, connected between the means (24) for determining the AC components and the associated inputs ($B_1$, $B_3$) of the digital electronic processing circuit (18), the electric signals V1 and V2 used by the means for computing the first quantity (R') being determined according to the equations:

$$V1 = B_1 + B_2$$

$$V2 = B_3 + B_4$$

in which $B_1$, $B_2$, $B_3$ and $B_4$ are respectively the signals applied to the inputs of the digital electronic processing circuit (18).

**Patentansprüche**

1. Anordnung zur Messung eines elektrischen Stroms durch Faradayeffekt, die

- eine Lichtquelle (1), welche ein einfallendes Lichtstrahlenbündel liefert,
- einen Eingangspolarisator (2) zur linearen Polarisierung des einfallenden Lichtstrahlenbündels,
- einen magneto-optischen Wandler (4), der mit dem polarisierten einfallenden Lichtstrahlenbündel beaufschlagt wird,
- einen an den Ausgang des Wandlers (4) geschalteten sowie ein erstes und ein zweites Ausgangs-Lichtstrahlenbündel liefernden Strahlenteiler (7),
- einen in den Pfad des ersten Ausgangs-Lichtstrahlenbündels geschalteten Ausgangspolarisator (8),
- sowie eine Verarbeitungseinheit (9) umfasst, welche einen an den Ausgang des Ausgangspolarisators angeschlossenen ersten optischen Eingang, einen das zweite Ausgangs-Lichtstrahlenbündel direkt vom Strahlenteiler empfangenden zweiten optischen Eingang sowie optoelektronische Wandlungsmittel (10) umfasst, die an den ersten und den zweiten optischen Eingang angeschlossen sind, um ein erstes und ein zweites elektrisches Signal (U1, U2) an Rechenmittel zur digitalen Berechnung des zu messenden Stroms (I) zu liefern,

**dadurch gekennzeichnet, dass** die Rechenmittel Mittel (12) zur Berechnung einer, durch das Verhältnis (U1/U2) zwischen dem ersten und dem zweiten elektrischen Signal (U1, U2) gebildeten ersten Größe (R), Mittel (13) zur Bestimmung der Wechselkomponente ($R_{AC}$) und der Gleichkomponente ($R_{DC}$) der ersten Größe, Mittel (14) zur Berechnung einer zweiten Größe (S) aus der Wechsel- und der Gleichkomponente der ersten Größe sowie Mittel (15) zur Berechnung des zu messenden Stroms (I) aus der zweiten Größe umfassen.

2. Anordnung nach Anspruch 1, **dadurch gekennzeichnet, dass** die zweite Größe (S) durch Bildung des Verhältnisses ($R_{AC}/R_{DC}$) zwischen der Wechselkomponente ($R_{AC}$) und der Gleichkomponente ($R_{DC}$) gewonnen wird.

3. Anordnung nach Anspruch 1, **dadurch gekennzeichnet, dass** die zweite Größe (S) über die Gleichung

$$S = \frac{R_{AC}}{1 + a(R_{DC} - 1)}$$

bestimmt wird, wobei $R_{AC}$ und $R_{DC}$ die Wechselkomponente bzw. die Gleichkomponente der ersten Größe und a einen Korrekturfaktor darstellen.

4. Anordnung nach irgendeinem der Ansprüche 1 bis 3, **dadurch gekennzeichnet, dass** der Strahlenteiler (7) so nah wie möglich an der Verarbeitungseinheit (9) angeordnet ist.

5. Anordnung nach Anspruch 4, **dadurch gekennzeichnet, dass** der Strahlenteiler (7) über eine polarisationserhaltende Monomode-Lichtleitfaser (6) an den Wandler (4) angeschlossen ist.

6. Anordnung nach irgendeinem der Ansprüche 1 bis 5, **dadurch gekennzeichnet, dass** die optoelektronischen Wandlungsmittel zwei Fotodioden (10) umfassen, die auf dem gleichen Halbleitersubstrat ausgebildet und dem ersten bzw. dem zweiten optischen Eingang der Verarbeitungseinheit (9) zugeordnet sind, wobei zwei auf einem gleichen Halbleitersubstrat (17) ausgebildete Verstärker (11) an die Ausgänge der Fotodioden (10) geschaltet sind.

7. Anordnung nach irgendeinem der Ansprüche 1 bis 6, **dadurch gekennzeichnet, dass** der Strahlenteiler (7) nichtpolarisierende Würfel (27, 28) umfasst.

8. Anordnung nach irgendeinem der Ansprüche 1 bis 6, **dadurch gekennzeichnet, dass** der Strahlenteiler (7) Trennplättchen (29, 30) umfasst.

9. Anordnung nach irgendeinem der Ansprüche 1 bis 6, **dadurch gekennzeichnet, dass** der Strahlenteiler (7) aus integriert-optischen Bauteilen (31, 32) besteht.

10. Anordnung nach irgendeinem der Ansprüche 1 bis 9, **dadurch gekennzeichnet, dass** die optoelektronischen Wandlungsmittel eine erste und eine zweite Fotodiode (10) umfassen, die an den ersten bzw. den zweiten optischen Eingang der Verarbeitungseinheit (9) angeschlossen sind, welche Verarbeitungseinheit (9) einen ersten und einen zweiten Verstärker (I1), die jeweils an den Ausgang der ersten bzw. zweiten Fotodiode angeschlossen sind, Mittel (19) zur Bestimmung der Gleichkomponente ($A_3$) der Ausgangssignale eines der genannten Verstärker, Mittel (20) zur Bestimmung einer ersten Differenz zwischen den Ausgangssignalen (U1, $A_3$) des ersten Verstärkers und der Mittel (19) zur Bestimmung der Gleichkomponente der Ausgangssignale eines der genannten Verstärker sowie Mittel (21) zur Bestimmung einer zweiten Differenz zwischen den Ausgangssignalen (U2, $A_3$) des zweiten Verstärkers und der Mittel (19) zur Bestimmung der Gleichkomponente der Ausgangssignale eines der genannten Verstärker umfasst, wobei die Ausgänge der Mittel (19) zur Bestimmung der Gleichkomponente der Ausgangssignale eines der genannten Verstärker und der Mittel (20, 21) zur Bestimmung der ersten und der zweiten Differenz an Eingänge einer elektronischen Digitalverarbeitungsschaltung (18) angeschlossen sind, welche Schaltung Mittel (F1) zur Bestimmung des von den Rechenmitteln (F2) zur Berechnung der ersten Größe (R) verwendeten ersten und zweiten elektrischen Signals in Abhängigkeit von den ihren Eingängen zugeführten Signalen ($A_1$, $A_2$, $A_3$) umfasst, wobei die Verarbeitungsschaltung (9) Verstärker (22) mit einem bestimmten Verstärkungsfaktor g umfasst, die zwischen die Mittel zur Bestimmung der ersten bzw. der zweiten Differenz und die zugeordneten Eingänge der elektronischen Digitalverarbeitungsschaltung (18) geschaltet sind und das von den Rechenmitteln zur Berechnung der ersten Größe verwendete erste bzw. zweite elektrische Signal Ui, mit i = 1 oder 2, über die Gleichung

$$Ui = (A_i / g) + A_3$$

bestimmt wird, wobei i = 1, 2 und $A_1$, $A_2$ und $A_3$ die den Eingängen der elektronischen Digitalverarbeitungsschaltung (18) zugeführten Signale darstellen.

11. Anordnung nach irgendeinem der Ansprüche 1 bis 9, **dadurch gekennzeichnet, dass** die optoelektronischen Wandlungsmittel eine erste und eine zweite Fotodiode (10) umfassen, die an den ersten bzw. den zweiten optischen Eingang der Verarbeitungseinheit (9) angeschlossen sind, welche Verarbeitungseinheit (9) einen ersten und einen zweiten Verstärker (11), die an den jeweiligen Ausgang der ersten bzw. zweiten Fotodiode angeschlossen sind, Mittel (23) zur Bestimmung der Gleichkomponenten (U1DC, U2DC) der Ausgangssignale (U1, U2) der genannten Verstärker sowie Mittel (24) zur Bestimmung der Wechselkomponenten (UIAC, U2AC) der Ausgangssignale (U1, U2) der genannten Verstärker umfasst, wobei die Ausgänge der Mittel (23, 24) zur Bestimmung der Gleich- und der Wechselkomponenten der Ausgangssignale der genannten Verstärker an Eingänge einer elektronischen Digitalverarbeitungsschaltung (18) angeschlossen sind, welche Schaltung Mittel (F6) zur Bestimmung der, von den Rechenmitteln (F7) zur Berechnung der ersten Größe (R') verwendeten elektrischen Signale (V1, V2) in Abhängigkeit von den ihren Eingängen zugeführten Signalen ($B_1$, $B_2$, $B_3$, $B_4$) umfasst, wobei die Verarbeitungsschaltung (9) Verstärker (25) mit einem bestimmten Verstärkungsfaktor g umfasst, die zwischen die Mittel (24) zur Bestimmung der Wechselkomponenten und die zugeordneten Eingänge ($B_1$, $B_3$) der elektronischen Digitalverarbeitungsschaltung (18) geschaltet sind und die von den Rechenmitteln zur Berechnung der ersten Größe (R') verwendeten elektrischen Signale V1 und V2 über die Gleichungen

$$V1 = B_1 + B_2$$

$$V2 = B_3 + B_4$$

bestimmt werden, wobei $B_1$, $B_2$, $B_3$ und $B_4$ die den Eingängen der elektronischen Digitalverarbeitungsschaltung (18) zugeführten Signale darstellen.

Fig. 1

Source lumineuse **1**

**2**

**3**

**4**

**5**

**6**

Séparateur de faisceau **7**

**8**

$I_1$

$I_2$

Unité de traitement **9**

EP 1 167 982 B1

Fig. 2

Fig. 3

$$U_i = (A_i/g) + A_3$$
$$i = 1,2$$

$F_1$

$$R = U_1/U_2$$

$F_2$

Détermination de $R_{AC}$ et $R_{DC}$

$F_3$

Calcul de S

$F_4$

Calcul de I

$F_5$

**Fig. 4**

Fig. 5

$$V1 = B_1 + B_2$$
$$V2 = B_3 + B_4$$

F6

$$R' = V1 / V2$$

F7

Détermination de
R'AC et RDC

F8

Calcul de S

F9

Calcul de I

F10 .

**Fig. 6**

EP 1 167 982 B1

**Fig. 7**

21

Fig. 8

**Fig. 9**